# EUROPÄISCHE PATENTSCHRIFT

(11) **EP 1 839 345 B1**
(45) Veröffentlichungstag und Bekanntmachung des Hinweises auf die Patenterteilung: **11.01.2012**
(21) Anmeldenummer: 06705806.5
(22) Anmeldetag: 18.01.2006
(51) Int. Cl.: H01L 41/083

(54) **PIEZOAKTOR MIT NIEDRIGER STREUKAPAZITÄT**
PIEZOACTUATOR WITH LOW STRAY CAPACITANCE
ACTIONNEUR PIEZO-ELECTRIQUE A FAIBLE CAPACITE PARASITE

(30) Priorität: 18.01.2005 DE 102005002428; 22.04.2005 DE 102005018791
(43) Veröffentlichungstag der Anmeldung: 03.10.2007
(73) Patentinhaber: EPCOS AG, 81669 München (DE)
(72) Erfinder: ALTHOFF, Anke, A-3423 St.-Andrä-Wördern (AT); FELTZ, Adalbert, A-8530 Deutschlandsberg (AT); FLORIAN, Heinz, A-8524 Bad Gams (AT)
(74) Vertreter: Epping, Wilhelm
(86) Internationale Anmeldenummer: PCT/DE2006/000067
(87) Internationale Veröffentlichungsnummer: WO 2006/076894

(56) Entgegenhaltungen:
- WO-A-03/026033
- WO-A-2005/053046
- WO-A-2005/069394
- DE-A1- 4 201 937
- PATENT ABSTRACTS OF JAPAN Bd. 013, Nr. 117 (E-731), 22. März 1989 (1989-03-22) -& JP 63 288075 A (NEC CORP), 25. November 1988 (1988-11-25)
- PATENT ABSTRACTS OF JAPAN Bd. 1995, Nr. 09, 31. Oktober 1995 (1995-10-31) -& JP 07 154005 A (TOKIN CORP), 16. Juni 1995 (1995-06-16)

## Beschreibung

Die Erfindung betrifft einen piezoelektrischen Aktor. Ein solcher Aktor kann beispielsweise zur Steuerung von Ventilen in einem Kraftfahrzeug verwendet werden.

Aus der Druckschrift DE 103 07 825 A1 ist ein piezoelektrischer Aktor mit Innenelektroden bekannt.

Die zu lösende Aufgabe besteht darin, einen Piezoaktor niedriger Streukapazität anzugeben.

Gemäß wenigstens einer Ausführungsform des hier beschriebenen Piezoaktors ist es vorgesehen, dass eine Vielzahl von übereinandergestapelten piezokeramischen Schichten einen Grundkörper bilden. Zwischen piezokeramischen Schichten sind Innenelektroden angeordnet, wobei zwei Sorten von Innenelektroden vorgesehen sein können.

Eine erste Sorte von Innenelektroden wird mit einem ersten Pol einer Spannungsquelle verbunden. Eine zweite Sorte von Innenelektroden wird mit einem zweiten Pol einer Spannungsquelle verbunden. Die Innenelektroden sind dabei so angeordnet, dass sie parallel geschaltete Kondensatoren bilden. Damit kann bei Anlegen einer Spannung die elektrische Energie in mechanische Energie aufgrund des inversen piezoelektrischen Effektes umgewandelt werden.

Des Weiteren weist der vorhandene Grundkörper wenigstens einen Randbereich auf, der frei ist von Innenelektroden. Der Randbereich kann direkt an eine Stirnseite des Stapels grenzen.

Vorzugsweise sind zwei Randbereiche vorgesehen, für jede Stirnseite des Stapels einer. In einem Randbereich des Piezoaktors ist vorzugsweise eine Deckschicht vorgesehen, die eine niedrige Dielektrizitätskonstante aufweist. Die Dielektrizitätskonstante ist vorzugsweise kleiner als 100, besonders bevorzugt kleiner als 20.

Gemäß wenigstens einer Ausführungsform ist es vorgesehen, dass die Dielektrizitätskonstante einer im Randbereich angeordneten Deckschicht kleiner ist als die Dielektrizitätskonstante der piezokeramischen Schichten. Die piezokeramischen Schichten müssen nicht notwendigerweise alle gleich sein, jedoch soll die Dielektrizitätskonstante der Deckschicht kleiner sein als die Dielektrizitätskonstante der benachbarten piezokeramischen Schicht.

Die Erfinder haben erkannt, dass die Streukapazität des Piezoaktors unter anderem beeinflusst wird durch die Dielektrizitätskonstante des Materials im Randbereich des Grundkörpers.

Mit Hilfe einer solchen Deckschicht kann daher ein Piezoaktor mit sehr geringer Streukapazität angegeben werden. Dies liegt darin begründet, dass die kapazitive Kopplung des Piezoaktors zu seiner Umgebung unter anderem auch bestimmt wird durch die auf der Oberseite beziehungsweise auf der Unterseite des Stapels angeordneten Schichten beziehungsweise deren Dielektrizitätskonstante. Die kapazitive Kopplung am Rand des Kondensators ist umso größer, je größer die Dielektrizitätskonstante in diesem Bereich ist. Eine Deckschicht im Randbereich des Grundkörpers mit einer sehr niedrigen Dielektrizitätskonstante kann die Streukapazität verringern.

In einer besonders bevorzugten Ausführungsform des Piezoaktors ist es vorgesehen, dass die Deckschicht ein keramisches Material enthält, beispielsweise Aluminiumoxid.

JP 63-288075 A offenbart ein piezokeramisches Vielschichtbauelement mit passiven Deckschichten, die Löcher aufweisen und damit kleinere elektrostatische Kapazität als die aktiven Schichten haben.

Aus den nicht vorveröffentlichten WO 2005/069394 A1 und WO 2005/053046 A1 sind piezokeramische Vielschichtaktoren mit passiven Deckschichten aus Materialien, die niedrigere Dielektrizitätskonstante als die aktiven Schichten aufweisen, bekannt, wobei diese auf den Stapel beispielsweise aufgeklebt beziehungsweise mit dem Stapel versintert sind.

Gemäß der Erfindung ist es vorgesehen, dass die Deckschicht mit einer daran angrenzenden piezokeramischen Schicht oder auch mit einer daran angrenzenden keramischen Schicht, die nicht notwendigerweise einen piezoelektrischen Effekt aufweisen muss, versintert und zur Anpassung der sintertemperatur und des schwindungsverhaltens mit einer Glasfritte versehen ist. Dadurch kann eine besonders innige Verbindung zwischen der Deckschicht und dem Rest des Piezoaktors hergestellt werden.

Des Weiteren kann die Herstellung besonders schnell und einfach erfolgen, da durch das Gemeinsamsintern von piezokeramischen Schichten mit Innenelektroden und die gemeinsame Sinterung der piezoelektrischen Schichten zusammen mit einer oder mehreren Deckschichten zu einem monolithischen Bauelement führt, das besonders gute elektromechanische Eigenschaften und auch eine erhöhte mechanische Stabilität aufweist.

Gemäß einer anderen Ausführungsform des Piezoaktors ist es vorgesehen, dass der Grundkörper beziehungsweise der Stapel übereinander liegender, gegebenenfalls gemeinsam versinterter Schichten versehen ist mit einem Mittel zum Erzeugen einer Vorspannung. Ein solches Mittel kann beispielsweise eine Druckspannung als Vorspannung für den Piezoaktor erzeugen. Beim Ausdehnen des Piezoaktors muss dann Arbeit gegen die Vorspannung geleistet werden. Beim Wegnehmen der äußeren elektrischen Spannung kehrt der Aktor zumindest teilweise aufgrund der Vorspannung automatisch in seinen unausgedehnten, das heißt verkürzten Grundzustand zurück.

Ein geeignetes Mittel zum Erzeugen einer mechanischen Vorspannung kann beispielsweise eine Rohrfeder sein.

Ein Mittel zur Erzeugen einer Vorspannung kann an einer oder mehreren Stirnflächen des Grundkörpers anliegen. Dadurch entsteht wiederum eine Kopplung der Stirnseiten des Grundkörpers an die Umgebung, womit die Deckschichten eine besondere Bedeutung für die elektrische Kopplung erlangen.

Im folgenden wird ein Piezoaktor anhand von Ausführungsbeispielen und den dazugehörigen Figuren näher erläutert:
- Figur 1: zeigt die Einbausituation eines Piezoaktors in einem Kraftfahrzeug.
- Figur 2: zeigt beispielhaft einen Piezoaktor in einem schematischen Längsschnitt.
- Figur 3: zeigt einen weiteren beispielhaften Piezoaktor in einem schematischen Längsschnitt.

Elemente des Piezoaktors die gleich sind oder die die gleiche Funktion aufweisen sind mit den selben Bezugzeichen gekennzeichnet. Im übrigen sind die Darstellungen nicht maßstabsgetreu, sondern zur besseren Erkennbarkeit entweder verkleinert oder vergrößert und gegebenenfalls auch in den Proportionen verzerrt.

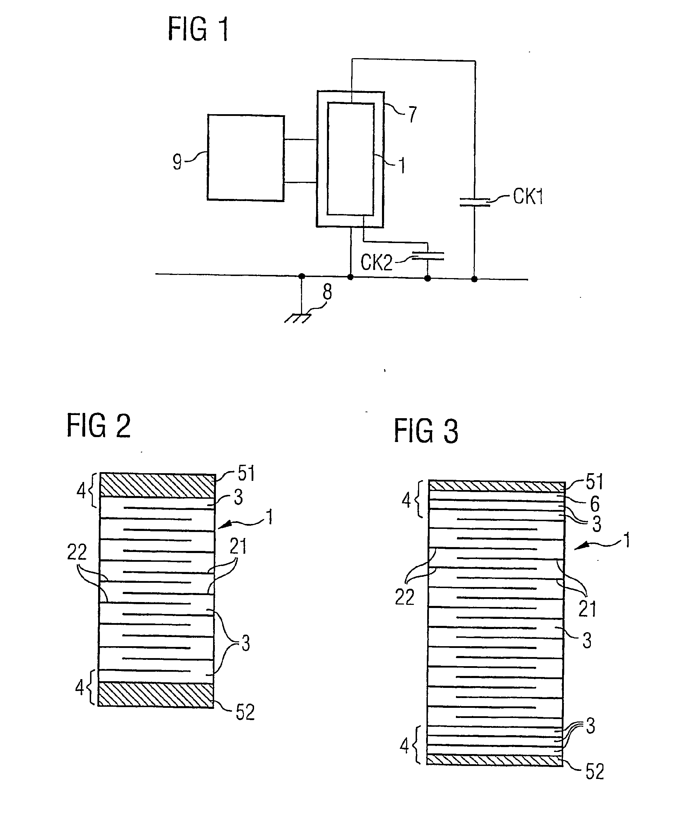

Figur 1 zeigt einen Piezoaktor mit einem Stapel 1 von übereinander liegenden Schichten. Der Piezoaktor ist verbunden mit einer elektrischen Schaltung 9, die zur Ansteuerung des Piezoaktors dient. Ferner ist vorgesehen eine Rohrfeder 7 zur Erzeugung einer mechanischen Vorspannung für den Piezoaktor. Aufgrund der so dargestellten Einbausituation besteht eine elektrische Kopplung des Piezoaktors, insbesondere der beiden Stirnseiten des Stapels 1 zur Masse 8 des Kraftfahrzeugs. Die kapazitive Kopplung zur Masse wird repräsentiert durch die beiden Koppelkondensatoren CK1 und CK2. Es kann vorkommen, dass beim Betrieb des Aktors, insbesondere beim mechanischen Belasten des Aktors unkontrollierbare Ladungen entstehen, welche über die Koppelkondensatoren CK1 und CK2 zur Fahrzeugmasse fließen.

Unter anderem durch Verwenden von Deckschichten mit niedriger Dielektrizitätskonstante kann das Problem der Streukapazität vermindert werden.

Durch die Verwendung von Deckschichten, die eine niedrige Dielektrizitätskonstante haben, resultiert für die Streukapazität, die die Koppelkondensatoren CK1 und CK2 repräsentieren, ein verringerter Wert. Insbesondere kann ein höherer elektrischer Widerstand bei Wechsellast erreicht werden.

Die Figuren 2 und 3 zeigen im Längsschnitt einen Piezoaktor mit übereinander gestapelten piezokeramischen Schichten 3. Die piezokeramischen Schichten 3 bilden einen Stapel 1 beziehungsweise einen Grundkörper. Darüber hinaus enthält der Stapel 1 noch Randbereiche 4, jeweils auf der Oberseite und auf der Unterseite. Die Randbereiche 4 sind frei von Innenelektroden und nehmen somit an dem aktiven Teil des Schichtpaketes nicht teil. Am oberen und unteren Rand des aktiven Paketes ist jeweils noch einen zusätzliche piezokeramische Schicht 3 angeordnet. Innerhalb des aktiven Paketes sind Innenelektroden 21 einer ersten Sorte und Innenelektroden 22 einer zweiten Sorte angeordnet, die kammartig ineinander greifen und nach Art eines Vielschichtkondensators angeordnete Strukturen bilden. Die äußere Kontaktierung der Innenelektroden 21, 22 ist in den Figuren nicht dargestellt, kann aber mit geeigneten Mitteln realisiert werden. Die piezokeramischen Schichten 3 werden übereinander gestapelt, mit Innenelektroden versehen und anschließend verpresst und versintert.

Gemäß Figur 2 ist es vorgesehen, dass im Randbereich 4 auf der Oberseite und auf der Unterseite des Stapels 1 jeweils eine Deckschicht 51, 52 angeordnet ist. Diese Deckschicht wird aus einem geeigneten Keramikmaterial gebildet, das die gemeinsame Versinterung mit den übrigen piezokeramischen Schichten 3 erlaubt.

Beispielsweise kann in einem Ausführungsbeispiel gemäß Figur 2 als Material für die Deckschicht vorgesehen sein ein Material der Zusammensetzung Ba₆₋ₓ(Sa_{y}Nd_{1-y})_{8+2x/3}Ti₁₈O₅₄. Dabei wird die für eine Gemeinsamsinterung mit der Piezokeramik erforderliche Anpassung der Sintertemperatur und des Schwindungsverhaltens durch einen geeigneten Zusatz einer Glasfritte, vorzugsweise eines Zinkborosilikatglases, erreicht. Für die Zusammensetzungsparameter des Deckschichtkeramikmaterials werden für x und y die folgenden Parameterwerte verwendet:
x = 1,5; y = 0,9
x = 2; y = 0,7.

Eine solche Zusammensetzung ist besonders gut zur Gemeinsamsinterung mit einer Piezokeramik geeignet. Die Dielektrizitätskonstante des angegebenen Materials für eine derartige Deckschicht beträgt in etwa 80.

Die angegebene Formulierung ist insbesondere geeignet für Piezoaktoren, bei denen die Innenelektroden aus Kupfer bestehen oder Kupfer enthalten. In diesem Fall wird beispielsweise als Piezokeramik das folgende Material verwendet:
Pb_{0,97}Nd₀,₀₂V_{0,01}(Zr_{0,53}Ti₀,₄₇)O₃.

Dabei steht V für eine Leerstelle. Die Gemeinsamsinterung erfolgt in etwa bei 1000 °C, so dass Kupferelektroden nicht beschädigt werden.

In einem anderen Ausführungsbeispiel gemäß Figur 2 ist es vorgesehen, die Innenelektroden aus einer Legierung von Silber und Palladium zu bilden. In diesem Fall kann bei etwas höheren Temperaturen gesintert werden. Entsprechend wird beispielhaft als Keramikmaterial für die Deckschicht eine Zusammensetzung verwendet, die wie folgt lautet:
(Ba₃,₆₀₃Pb_{0,205}Bi₁,₃₇₁Nd_{7,681}Pr_{0,189})(Ti_{17,885}Nb_{0,115}O₅₄).

Diese Zusammensetzung wird zwecks Schwundanpassung und Anpassung der Sintertemperatur an die Piezokeramik mit einem Anteil an Glasfritte versehen. Es ist ein Merkmal der in diesem Ausführungsbeispiel verwendeten Keramik, die mit V bezeichneten Leerstellen während des Sinterns durch Aufnehmen von Silber aus den Silber-Palladium-Innenelektroden zu besetzen, sodass dann die Zusammensetzung
Pb_{0,79}Nd_{0,02}Ag_{0,02}(Zr_{0,53}Ti_{0,47})O3 vorliegt.

Eine etwas variierte Zusammensetzung (V wird ersetzt durch Ag) wird in diesem Fall für die piezokeramischen Schichten verwendet.

Die Dielektrizitätskonstante des Materials der Deckschicht beträgt in etwa 90.

Im Vergleich dazu wird die Dielektrizitätskonstante für die Piezokeramik angegeben mit einem Wert von cirka 3000 bis 3500.

Die Dielektrizitätskonstante der Deckschicht ist also mindestens um den Faktor 10, gegebenenfalls sogar um den Faktor 100 kleiner als die Dielektrizitätskonstante der piezokeramischen Schichten.

Dies gilt insbesondere auch für eine Äusführung gemäß Figur 3, die nicht unter den Schutzbereich der Ansprüche fällt. Dort wird nach Herstellen des aktiven Paketes zur Bildung des Piezoaktors auf die oberste piezokeramische Schicht 3 mittels einer Klebeschicht 6 eine Deckschicht 51 aufgebracht, die zum Beispiel Aluminiumoxid enthalten kann, und/oder es wird in gleicher Weise auch die unterste piezokeramische Schicht mit einer analog fixierten Deckschicht versehen. Die genannten Materialien haben eine Dielektrizitätskonstante von etwa 10 und sind damit cirka um den Faktor 300 kleiner als die Dielektrizitätskonstante der Piezokeramik.

Die Deckschichten 51, 52 in Figur 3 können beispielsweise aus einer gesinterten Aluminiumoxid-Keramik bestehen und als gesinterte Scheibe vorliegen.

### Bezugszeichenliste

- 1: Stapel
- 21, 22: Innenelektrode
- 3: Piezokeramische Schicht
- 4: Randbereich
- 51, 52: Deckschicht
- 6: Kleber
- 7: Rohrfeder
- 8: Masse
- 9: Schaltung
- CK1, CK2: Koppelkondensatoren

## Patentansprüche

1. Piezoelektrischer Aktor
- mit einem Stapel (1) von übereinander liegenden piezokeramischen Schichten (3),
- mit Innenelektroden (2), die zwischen den piezokeramischen Schichten (3) angeordnet sind,
- bei dem wenigstens ein Randbereich (4) des Stapels (1) frei von Innenelektroden (21, 22) ist,
- bei dem im Randbereich (4) eine Deckschicht (51, 52) angeordnet ist, deren Dielektrizitätskonstante kleiner ist als die Dielektrizitätskonstante einer piezokeramischen Schicht (3) und
- bei dem die Deckschicht (51, 52) mit einer angrenzenden Schicht versintert ist und zur Anpassung der Sintertemperatur und des Schwindungsverhaltens mit einem Zusatz einer Glasfritte versehen ist.

2. Aktor nach Anspruch 1,
bei dem die Deckschicht (51, 52) ein Keramikmaterial enthält.

3. Aktor nach Anspruch 2,
bei dem für die Deckschicht (51, 52) ein Material mit der Zusammensetzung Ba₆-ₓ(Sa_{y}Nd_{1-y})_{8+2x/3}Ti₁₈O₅₄ verwendet wird.

4. Aktor nach einem der Ansprüche 1 bis 3,
der mit einer Vorrichtung (7) zum Erzeugen einer mechanischen Vorspannung versehen ist.

5. Aktor nach Anspruch 4,
bei dem die Vorrichtung (7) als Rohrfeder ausgebildet ist.

6. Aktor nach einem der Ansprüche 4 oder 5,
der über die Vorrichtung (7) an eine Masse (8) angeschlossen ist.

7. Aktor nach Anspruch 6,
bei dem die Streukapazität, die durch den Masseschluss verursacht wird, mittels der Anwendung von Deckschichten (51, 52) niedriger Dielektrizitätskonstante herabgemindert ist.

8. Aktor nach einem der Ansprüche 4 bis 7,
bei dem die Vorrichtung (7) an den Stirnseiten des Stapels (1) anliegt.

## Claims

1. Piezoelectric actuator
- comprising a stack (1) of piezoceramic layers (3) laying one above another,
- comprising internal electrodes (2) arranged between the piezoceramic layers (3),
- wherein at least one edge region (4) of the stack (1) is free of internal electrodes (21, 22),
- wherein a covering layer (51, 52) is arranged in the edge region (4), the dielectric constant of said covering layer being less than the dielectric constant of a piezoceramic layer (3), and
- wherein the covering layer (51, 52) is sintered with an adjoining layer and is provided with an addition of a glass frit in order to adapt the sintering temperature and the shrinkage behaviour.

2. Actuator according to Claim 1,
wherein the covering layer (51, 52) contains a ceramic material.

3. Actuator according to Claim 2,
wherein a material having the composition Ba₆₋ₓ(Sa_{y}Nd_{1-y})_{8+2x/3}Ti₁₈O₅₄ is used for the covering layer (51, 52).

4. Actuator according to any of Claims 1 to 3,
which is provided with a device (7) for producing a mechanical prestress.

5. Actuator according to Claim 4,
wherein the device (7) is embodied as a tubular spring.

6. Actuator according to either of Claims 4 and 5,
which is connected to an earth (8) via the device (7).

7. Actuator according to Claim 6,
wherein the stray capacitance caused by the earth connection is reduced by means of the use of covering layers (51, 52) having a low dielectric constant.

8. Actuator according to any of Claims 4 to 7,
wherein the device (7) adjoins the end sides of the stack (1).

## Revendications

1. Actionneur piézoélectrique présentant
- un empilement (1) de couches piézocéramiques (3) disposées les unes au-dessus des autres,
- des électrodes intérieures (2) disposées entre les couches piézocéramiques (3), au moins une bordure (4) de l'empilement (1) ne présentant pas d'électrodes intérieures (21, 22),
- une couche de recouvrement (51, 52) dont la constante diélectrique est inférieure à la constante diélectrique d'une couche piézocéramique (3) étant disposée dans la bordure (4) et
- la couche de recouvrement (51, 52) étant frittée avec une couche adjacente et dotée d'un additif de fritte de verre pour adapter la température de frittage et le comportement de retrait.

2. Actionneur selon la revendication 1, dans lequel la couche de recouvrement (51, 52) contient un matériau céramique.

3. Actionneur selon la revendication 2, dans lequel on utilise pour la couche de recouvrement (51, 52) un matériau de composition Ba₆₋ₓ(Sa_{y}Nd_{1-y})_{8+2x/3}Ti₁₈O₅₄.

4. Actionneur selon l'une des revendications 1 à 3, doté d'un dispositif (7) d'application d'une précontrainte mécanique.

5. Actionneur selon la revendication 4, dans lequel le dispositif (7) est configuré comme ressort tubulaire.

6. Actionneur selon l'une des revendications 4 ou 5, raccordé à une masse (8) par l'intermédiaire du dispositif (7).

7. Actionneur selon la revendication 6, dans lequel la capacité de diffusion provoquée par le raccordement à la masse est diminuée par le recours aux couches de recouvrement (51, 52) à plus basse constante diélectrique.

8. Actionneur selon l'une des revendications 4 à 7, dans lequel le dispositif (7) repose sur les côtés frontaux de l'empilement (1).
